Europäisches Patentamt

European Patent Office

Office européen des brevets

(19)

(11) **EP 1 078 999 A2**

(12) **EUROPEAN PATENT APPLICATION**

(43) Date of publication:
28.02.2001 Bulletin 2001/09

(51) Int Cl.7: **C23C 14/12**, H01L 51/20,
H01L 51/40

(21) Application number: 00307026.5

(22) Date of filing: 16.08.2000

(84) Designated Contracting States:
**AT BE CH CY DE DK ES FI FR GB GR IE IT LI LU MC NL PT SE**
Designated Extension States:
**AL LT LV MK RO SI**

(30) Priority: 20.08.1999 JP 23365499

(71) Applicant: **TDK Corporation**
**Chuo-ku, Tokyo (JP)**

(72) Inventors:
• **Hiroshi, Tanabe**
**Tokyo 103-8272 (JP)**
• **Tokura, Satoshi**
**Tokyo 103-8272 (JP)**

(74) Representative: **Sarup, David Alexander et al**
**Raworth, Moss & Cook,**
**Raworth House,**
**36 Sydenham Road**
**Croydon, Surrey CRO 2EF (GB)**

(54) **System and method for fabricating organic electroluminescent display devices**

(57) The invention has for its object to provide an organic EL display fabrication system and method which are well compatible with a substrate having a relatively large area and ensure a small film-thickness distribution, high material usage efficiency, a high practical rate during film formation and a constant doping concentration, and so enable organic EL display devices of high quality to be mass-fabricated with efficiency yet at low cost. The fabrication system comprises a substrate on which said organic EL display device is to be formed, a means for rotating said substrate, an evaporation source for a host material and an evaporation source for a guest material. An n value is 3 to 10 for the evaporation source for a host material and 8 to 18 for the evaporation source for a guest material as given by an approximate equation $m/m_0 = (L_0/L)^2 \cdot \cos^n \theta$ where $m_0$ is the vapor density at a center on an opening in each evaporation source and at a distance Lo from the opening and m is the vapor density at any position located at a radial angle $\theta$ from the center line of the opening and spaced away from the opening by a distance L. The evaporation source for a host material is positioned with respect to the center of the substrate such that the evaporation source is located at a position that is 1.0 to 2.0 times as long as the center-to-end distance of the substrate. The evaporation source for a guest material is positioned with respect to the center of the substrate such that the evaporation source is located at a position that is 0.5 to 1.0 time as long as the center-to-end distance of the substrate. The vertical distance from the opening in each evaporation source to a plane including a substrate surface is 1.0 to 3.5 times as long as the center-to-end distance of the substrate. The evaporation source for a host material and the evaporation source for a guest material are simultaneously used for simultaneous evaporation of at least two materials. In the fabrication method of the invention, this system is used for evaporation.

**EP 1 078 999 A2**

## Description

## BACKGROUND OF THE INVENTION

### FIELD OF THE INVENTION

The present invention relates generally to an organic EL (electroluminescent) device fabrication system, and more particularly to a system for fabricating an organic EL display device using an evaporation process wherein an organic starting material for an organic EL device is evaporated by heating, so that the organic starting material is deposited on a film-forming area on a substrate to form a thin film thereon.

### PRIOR ART

Among fundamental techniques known for thin-film formation, there is a vacuum evaporation process wherein a thin film is formed using an appropriately combined evaporation source and film-forming substrate in a vacuum chamber. Various means for preparing the evaporation source are available to this end. For instance, a so-called resistance-heating evaporation process is known, wherein currents are passed through a metal vessel (metal board) having a relatively high electric resistance, so that heat is generated to evaporate the starting material, as set forth in "Applied Physics Letter", Vol. 68, No. 16, 15 April 1996, pp. 2276-2278. There is also known a so-called electron beam-laser beam evaporation process wherein the starting material is directly irradiated with electron or laser beams, so that the starting material is evaporated by the resulting energy. Among these, the film-formation process (resistance-heating evaporation process) making use of resistance heating now finds wide applications because the film-formation system used is simple in structure and capable of forming a thin film of good quality at low costs.

According to the resistance-heating evaporation process, a high-melting metal material such as tungsten, tantalum and molybdenum is processed into a thin sheet having an increased electric resistance, from which a starting material container (metal board) is in turn prepared. Then, a direct current is passed across the container to generate heat, which is used to evaporate the starting material, thereby providing a supply of evaporated gas. A part of the diffused gas is deposited on a substrate for thin-film formation. For the evaporation starting material used, any material having a relatively high vapor pressure may be used; however, materials susceptible to chemical reactions with the starting container must be avoided.

Such a resistance heating system causes less damage to organic layers, and so can be advantageously used as evaporation equipment for forming thin films constituting an organic EL device, for instance, organic films and cathodes. However, a substrate on which a thin film can be formed with such a vacuum evaporation system is limited to that having a relatively small size of the order of 100 x 100 mm, when it is intended to achieve uniform film thickness. Thus, when organic EL display devices are mass-fabricated by arranging organic EL devices on a matrix and making an appropriate selection from light-emitting elements to form characters, images or the like, thereby displaying thereon information, etc., the number of display devices that can be fabricated in one operation is limited with a fabrication efficiency drop. In addition, some limitation is imposed on the size of manufacturable screens, making the application of organic EL display devices to large screens difficult.

When no care is taken of any thickness variation, on the other hand, a film can be formed even on some large substrate. However, performance instability causes an increased percentage of rejects, and increased luminance and display variations in one display device. Thus, it is still difficult to achieve practically acceptable quality.

In consideration of practicability on an industrial level, a problem with the resistance heating system using a metal board is that the amount of the material to be charged therein is limited.

As one means for solving these problems, a process is now investigation, wherein a cell type evaporation source capable of increasing the amount of the material to be fed is used to rotate a substrate while the position relation of the evaporation source with respect to the substrate is properly controlled with controlled directivity of the evaporation source (JP-A 10-335062).

On the other hand, the light emitting layer in an organic EL device is often adjusted to the desired light emission properties by doping one or two or more host substances with ultra-trace amounts of one or two or more fluorescent substances. However, even slight deviations from the proper doping amount have fatal influences on light emission properties.

When the cell type evaporation source is used to form a film form of doped layer, there is a doping concentration distribution within a plane, which is caused by a difference in the directivity of evaporation between the high rate corresponding to the evaporation of the host material and the low rate corresponding to the evaporation of a guest material. This in turn causes organic EL devices disposed within a substrate to have varying properties and each organic EL device to have a property distribution therein.

It is therefore an object of the present invention to provide an organic EL display fabrication system and method which are well compatible with a substrate having a relatively large area and ensure a small film-thickness distribution, high material usage efficiency, a high practical rate during film formation and a constant doping concentration, and so enable organic EL display devices of high quality to be mass-fabricated with efficiency yet at low cost.

## SUMMARY OF THE INVENTION

The aforesaid object is achievable by the embodiments of the invention defined below as (1) to (10).

(1) An organic electroluminescent display device fabrication system comprising a substrate on which said organic EL display device is to be formed, a means for rotating said substrate, an evaporation source for a host material and an evaporation source for a guest material, wherein:

an n value is 3 to 10 for said evaporation source for a host material and 8 to 18 for said evaporation source for a guest material as given by an approximate equation $m/m_0 = (L_0/L)^2 \cdot \cos^n \theta$ where $m_0$ is a vapor density at a center on an opening in each evaporation source and at a distance $L_0$ from said opening and m is a vapor density at any position located at a radial angle $\theta$ from a center line of said opening and spaced away from said opening by a distance L, said evaporation source for a host material is positioned with respect to a center of said substrate such that said evaporation source is located at a position that is 1.0 to 2.0 times as long as a center-to-end distance of said substrate, said evaporation source for a guest material is positioned with respect to the center of said substrate such that said evaporation source is located at a position that is 0.5 to 1.0 time as long as the center-to-end distance of said substrate, a vertical distance from said opening in each evaporation source to a plane including a substrate surface is 1.0 to 3.5 times as long as the center-to-end distance of said substrate, and said evaporation source for a host material and said evaporation source for a guest material are simultaneously used for simultaneous evaporation of at least two materials.

(2) The fabrication system according to (1) above, wherein the center line of each evaporation source is at an angle of 1 to 45 degrees with respect to the perpendicular going from said plane including the substrate surface down to each evaporation source.

(3) The fabrication system according to (1) or (2) above, wherein said substrate has a maximum length of 200 to 1,000 mm.

(4) The fabrication system according to any one of (1) to (3) above, wherein the organic layer to be formed has a film-thickness distribution of $\pm$ 10% or less.

(5) The fabrication system according to any one of (1) to (4) above, wherein the rate of evaporation of said guest material is within 0.1 to 10% of the rate of evaporation of said host material.

(6) The fabrication system according to any one of (1) to (5) above, wherein the center positions of said evaporation sources subjected to said simultaneous evaporation are located within an angle of 90° as viewed from the center of said substrate.

(7) The fabrication system according to any one of (1) to (6) above, wherein during evaporation said substrate is rotated by said rotation means at a rate of at least 10 rpm.

(8) An organic electroluminescent display device fabrication method, wherein film formation is effected by a system as recited in any one of (1) to (7) above.

(9) The fabrication method according to (8) above, wherein evaporation is effected such that a film thickness of 10 Å or less is obtained per rotation of said substrate.

(10) The fabrication method according to (8) or (9) above, wherein the doped layer to be formed has a concentration distribution in a thickness direction thereof, with a maximum value of concentration being at most 3 times as large as an average value of concentration in said layer.

## BRIEF DESCRIPTION OF THE DRAWINGS

FIG. 1 is a sectional view showing a half of one general construction of the system of the invention.
FIG. 2 is a plan view of FIG. 1.
FIG. 3 is a sectional view of part of a Knudsen cell used preferably with the system of the invention.
FIG. 4 is a graph showing an evaporation rate vs. n value relation (using Alq3).

## PREFERRED EMBODIMENTS OF THE INVENTION

According to the invention, there is provided an organic electroluminescent display device fabrication system comprising a substrate on which said organic EL display device is to be formed, a means for rotating said substrate, an evaporation source for a host material and an evaporation source for a guest material, wherein:

an n value is 3 to 10 for said evaporation source for a host material and 8 to 18 for said evaporation source for a guest material as given by an approximate equation $m/m_0 = (L_0/L)^2 \cdot \cos^n \theta$ where $m_0$ is a vapor density at a center on an opening in each evaporation source and at a distance $L_0$ from said opening and m is a vapor density at any position located at a radial angle $\theta$ from a center line of said opening and spaced away from said opening by a distance L, said evaporation source for a host material is positioned with respect to a center of said substrate such that said evaporation source is located at a position that is 1.0 to 2.0 times as long as a center-to-end distance of said substrate,

said evaporation source for a guest material is positioned with respect to the center of said substrate such that said evaporation source is located at a position that is 0.5 to 1.0 time as long as the center-to-end distance of said substrate,

a vertical distance from said opening in each evaporation source to a plane including a substrate surface is 1.0 to 3.5 times as long as the center-to-end distance of said substrate, and

said evaporation source for a host material and said evaporation source for a guest material are simultaneously used for evaporation of at least two materials.

Thus, at least one evaporation source for the evaporation of the host material at a high rate and at least one evaporation source for the evaporation of the guest material at a low rate are provided. By effecting evaporation while the n values for these evaporation sources are regulated to the optimum ones and the vertical and horizontal positions of the substrate from its center to the evaporation sources are controlled, it is possible to obtain an organic layer having a reduced film thickness variation at a practically high film-deposition rate yet at a constant doping concentration as well as with high efficiency in using materials.

For the evaporation sources for the host and guest materials, those of the same specification may be separately provided or different designs may be used. When a carrier injecting layer, a carrier transporting layer and other layers, for which no doping is needed, are formed each in a film form, it is preferable to use evaporation sources for the host material.

Requirements for evaporation sources are that (1) stable and precise temperature control is achievable, (2) the film-deposition rate is controllable, (3) the evaporation sources are less susceptible to chemical reactions with the constituents of an organic EL display device, and (4) the starting materials can be easily diffused into a vapor state in a stable manner. Additional requirements for the evaporation source for the host material are that (5) the film-deposition rate is so relatively high that mass-fabrication is achievable and (6) the feed of the starting material enough for a large substrate can be ensured.

No particular limitation is thus imposed on the evaporation sources used herein with the proviso that they can meet such requirements; that is, various evaporation sources may be used. For such an evaporation source, it is preferable to use a Knudsen cell (hereinafter often called the K cell). The Knudsen cell is a cell having a given opening at a vapor jetting port. Given an opening diameter d and a film thickness t as parameters, the distribution of vapor density on the jetting port is an approximate form of $\cos^n \theta$. Represented by the value of n is an approximate equation of $m/m_0 \propto \cos^n \theta$, where m is

the vapor density at any arbitrary position and $m_0$ is the vapor density at the center of the opening. The smaller d/t, the larger the n value is or the sharper the form of the flame is. In one extreme case where t = 0, n = 1 with a spherical distribution of vapor density on the opening. This is tantamount to evaporation from an open liquid surface, called Langmuir evaporation.

While the n value changes with the material used and varies depending on the rate of evaporation as well, yet it may be regulated to a certain extent by control of d/t, etc. It is noted, however, that it is very difficult to achieve the same n value for the host and guest materials that vary in the rate of evaporation by a factor of about 10 to about 100. For this reason, the n value should be between 3 and 10 and preferably between 4 and 8 for the evaporation source for the host material, and between 8 and 18 and preferably between 9 and 16 for the evaporation source for the guest material. This is because the vapor evaporating from the opening in the evaporation source, i.e., an orifice is variable with a variation in the n value. If the n value is within this range, then the system can work well. When the n value is smaller than the above lower limit, the spread of diffusion becomes too wide, resulting in a drop of film-formation efficiency. When the n value is greater than the above upper limit, the directivity of diffusion becomes too strong to accommodate to a large substrate.

The evaporation source for the host material is horizontally positioned with respect to the center of the substrate such that the evaporation source is located at a position that is 1.0 to 2.0 times, preferably 1.0 to 1.8 times and especially 1.1 to 1.6 times as long as the center-to-end distance of the substrate. Any deviation from this range renders it impossible to obtain any uniform film thickness distribution. The evaporation source for the guest material is horizontally positioned with respect to the center of the substrate such that the evaporation source is located at a position that is 0.5 to 1.0 time, preferably 0.6 to 0.9 times and especially 0.6 to 0.8 times as long as the center-to-end distance of the substrate. Any deviation from this range renders it impossible to obtain any uniform doping concentration distribution.

The vertical distance from the opening in the evaporation source to a plane including the surface of the substrate is 1.0 to 3.5 times, preferably 1.2 to 3.0 times and especially 1.4 to 2.5 times as long as the center-to-end distance of the substrate. By tilting the evaporation source at a given position offset away from the center of the substrate with respect to a constant range of n values, it is thus possible to achieve a uniform film thickness distribution, high material usage efficiency and high practical rate and, hence, obtain an organic EL display device of stable performance.

The evaporation source is also tilted with respect to the substrate side such that the center line of the evaporation source passing vertically through the surface of the opening in the evaporation source is at an angle of 1 to 45 degrees, preferably 3 to 30 degrees and especially 5 to 20 degrees with respect to the perpendicular going from the plane including the surface of the substrate down to the evaporation source. By tilting the evaporation source, it is thus possible to achieve high material usage efficiency, because the vertical distance between the evaporation source and the substrate can be made short while the film thickness distribution is kept in good condition.

For evaporation, the substrate is rotated by the rotating means. It is then preferable that the evaporation source is inclined with respect to the center of rotation. Here given a circular cylinder crossing vertically the substrate surface and having a radius that is 0 to 0.5 times and preferably 0 to 0.2 times as long as the center-to-end distance of the substrate, it is then preferable that the center line of the evaporation source crosses the circular cylinder. Furthermore, it is preferable that the center line of the evaporation source crosses the center of rotation of the substrate.

The rotating means for rotating the substrate may be built up of a known rotating mechanism comprising a power source such as a motor, a hydraulic rotating device or the like together with a power transmission/reduction mechanism comprising gears, belts, pulleys, etc. The substrate should preferably be rotated at 10 rpm or greater, preferably 10 to 50 rpm, and especially 10 to 30 rpm. When the rpm of the substrate is too high, problems arise in connection with sealability during the introduction of the substrate in a vacuum chamber. When the rpm of the substrate is too low, on the other hand, there is a composition variation in the thickness direction in the chamber, which in turn gives rise to a drop of the performance of the resulting organic EL device.

By carrying out evaporation while the substrate is rotated, it is thus possible to achieve a uniform film-thickness distribution, high material usage efficiency and practical rates even when a large substrate is used.

The thickness of the film deposited on the substrate per rotation of the substrate, viz., the rate of evaporation per rotation of the substrate should be preferably 10 Å or less, and more preferably 1 to 5 Å. Too thick a film gives rise to a composition variation in the thickness direction within the chamber. Too thin a film is likely to offer problems upon the introduction of rotation in the vacuum chamber.

By tilting or inclining the evaporation source, it is possible to achieve a satisfactory film-thickness distribution even over a short vertical distance. As already explained, the $m/m_0$ ratio may be given by the approximate equation

$$m/m_0 = (L_0/L)^2 \cdot (\cos \theta)^n$$

where $m_0$ is the vapor density at the center on the opening in the evaporation source and at the distance Lo from the opening and m is the vapor density at any position located at the radial angle $\theta$ from the center line of the opening and spaced away from the opening by the distance L. A reduction in the vertical distance is tantamount to a reduction in the distance L. In other words, it is possible to increase the rate of deposition onto the substrate while the rate of evaporation from the evaporation source is kept constant. That the rate of deposition onto the substrate can be increased while the rate of evaporation from the evaporation source is kept constant is tantamount to that it is possible to increase the material usage efficiency that is the rate of the material deposited onto the substrate with respect to the material evaporated from the evaporation source.

As mentioned above, it is possible to achieve a satisfactory film-thickness distribution even with a shorter vertical distance. In other words, it is possible to reduce system size even when setting up a system compatible with a large-area substrate.

If the evaporation source positioned with respect to the center of the substrate such that the evaporation source is located at the position that is 1.0 to 2.0 times as long as the center-to-end distance of the substrate is inclined with respect to the center side of the substrate, it is also possible to make effective use of the aforesaid spread, so that while the rate of evaporation from the evaporation source is kept constant, the rate of deposition onto the substrate can be increased with an increase in material usable efficiency.

Within the aforesaid range, a plurality of evaporation sources for each of the host and guest materials may be located concentrically with respect to the center of the substrate. Preferably in this case, evaporation source for the host material and the evaporation source for the guest material should be disposed within the angle range of preferably 90°, and more preferably 60° as viewed from the center axis of the substrate. By disposing the evaporation sources within such an angle range, it is possible to reduce a variation in the doping concentration in the thickness direction.

The film-thickness distribution of the thus formed thin film should be within preferably ± 10%, more preferably ± 9%, and even more preferably ± 8%. A film-thickness distribution greater than ± 10% causes the performance of an organic EL display device to become unstable.

When the formed film is a mixed layer, the doped layer may have a guest material concentration distribution in the thickness direction. Preferably in this case, the concentration of the guest material should have a maximum value that is at most 3 times and especially about 1 to 2 times as large as the concentration of the guest material in the film.

Thin films formed for the constituents of an organic EL display device with the system according to the present invention, for instance, include a hole injecting and transporting layer, a combined light emitting and electron injecting/transporting layer, an electron injecting electrode, and a protective layer. The materials used for these thin films may be metal materials, alloy materials and organic materials having the same composition as the thin films or capable of providing the same composition by evaporation.

For the electron injecting electrode material, it is preferable to use a substance having a low work function. For instance, use may be made of pure metal elements such as K, Li, Na, Mg, La, Ce, Ca, Sr, Ba, Al, Ag, In, Sn, Zn, and Zr, and a binary or ternary alloy system serving as a stabilizer and containing those elements. Exemplary alloys are Ag-Mg (Ag: 0.1 to 50 at%), Al-Li (Li: 0.01 to 14 at%, and especially 0.01 to 12 at%), In-Mg (Mg: 50 to 80 at%), and Al-Ca (Ca: 0.01 to 20 at%). For the electron injecting electrode layer, a thin film comprising one of these materials or a multilayer thin film comprising two or more of these material may be used.

For the protective layer, metal materials, inorganic material such as $SiO_x$, and organic materials such as Teflon may be used.

For the light emitting layer a fluorescent material that is a compound capable of emitting light is used. The fluorescent material used herein, for instance, may be at least one compound selected from compounds such as those disclosed in JP-A 63-264692, etc., quinacridone, rubrene, and styryl dyes. Use may also be made of quinoline derivatives such as metal complex dyes containing 8-quinolinol or its derivatives as ligands, for instance, tris(8-quinolinolato) aluminum, tetraphenylbutadiene, anthracene, perylene, coronene, and 12-phthaloperinone derivatives. Use may further be made of phenylanthracene derivatives disclosed in JP-A 8-12600 (Japanese Patent Application No. 6-110569) and tetraarylethene derivatives disclosed in JP-A 8-12969 (Japanese Patent Application No. 6-114456).

Preferably, the fluorescent compound is used in combination with a host substance capable of emitting light by itself; that is, it is preferable that the fluorescent compound is used as a dopant. In such a case, the content of the dopant in the light emitting layer is in the range of preferably 0.01 to 10 % by volume, and especially 0.1 to 5% by volume. The content of a rubrene dopant is preferably in the range of 0.01 to 20% by volume. By using the fluorescent compound in combination with the host substance, it is possible to vary the wavelength performance of light emission of the host substance, thereby making light emission possible on a longer wavelength side and, hence, improving the light emission efficiency and stability of the device.

Quinolinolato complexes, and aluminum complexes containing 8-quinolinol or its derivatives as ligands are preferred for the host substance. Such aluminum complexes are typically disclosed in JP-A's 63-264692, 3-255190, 5-70733, 5-258859, 6-215874, etc.

Exemplary aluminum complexes include tris(8-quinolinolato)aluminum, bis(8-quinolinolato)magnesium, bis(benzo{f}-8-quinolinolato)zinc, bis(2-methyl-8-quinolinolato)aluminum oxide, tris(8-quinolinolato)indium, tris(5-methyl-8-quinolinolato)aluminum, 8-quinolinolatolithium, tris(5-chloro-8-quinolinolato)gallium, bis(5-chloro-8-quinolinolato)calcium, 5,7-dichloro-8-quinolinolato-aluminum, tris(5,7-dibromo-8-hydroxyquinolinolato)aluminum, and poly[zinc(II)-bis(8-hydroxy-5-quinolinyl)methane].

Use may also be made of aluminum complexes containing other ligands in addition to 8-quinolinol or its derivatives, for instance, bis(2-methyl-8-quinolinolato)(phenolato) aluminum (III), bis(2-methyl-8-quinolinolato)(o-cresolato) aluminum (III), bis(2-methyl-8-quinolinolato)(m-cresolato) aluminum (III), bis(2-methyl-8-quinolinolato)(p-cresolato) aluminum (III), bis(2-methyl-8-quinolinolato)(o-phenylphenolato)aluminum (III), bis(2-methyl-8-quinolinolato)(m-phenylphenolato)aluminum (III), bis(2-methyl-8-quinolinolato)(p-phenylphenolato)aluminum (III), bis(2-methyl-8-quinolinolato)(2,3-dimethylphenolato)aluminum (III), bis(2-methyl-8-quinolinolato)(2,6-dimethylphenolato) aluminum (III), bis(2-methyl-8-quinolinolato)(3,4-dimethylphenolato) aluminum (III), bis(2-methyl-8-quinolinolato)(3,5-dimethylphenolato)aluminum (III), bis(2-methyl-8-quinolinolato)(3,5-di-tert-butylphenolato)aluminum (III), bis(2-methyl-8-quinolinolato)(2,6-diphenylphenolato)aluminum (III), bis(2-methyl-8-quinolinolato)(2,4,6-triphenyl-phenolato)aluminum (III), bis(2-methyl-8-quinolinolato) (2,3,6-trimethylphenolato) aluminum (III), bis(2-methyl-8-quinolinolato) (2,3,5,6-tetramethylphenolato)aluminum (III), bis(2-methyl-8-quinolinolato)(1-naphtholato)aluminum (III), bis(2-methyl-8-quinolinolato) (2-naphtholato)aluminum (III), bis(2,4-dimethyl-8-quinolinolato)(o-phenylphenolato)aluminum (III), bis(2,4-dimethyl-8-quinolinolato)(p-phenylphenolato) aluminum (III), bis(2,4-dimethyl-8-quinolinolato)(m-phenylphenolato)aluminum (III), bis(2,4-dimethyl-8-quinolinolato) (3,5-dimethylphenolato)aluminum (III), bis (2,4-dimethyl-8-quinolinolato) (3,5-di-tert-butylphenolato)aluminum (III), bis(2-methyl-4-ethyl-8-quinolinolato) (p-cresolato)aluminum (III), bis(2-methyl-4-methoxy-8-quinolinolato)(p-phenylphenolato)aluminum (III), bis (2-methyl-5-cyano-8-quinolinolato)(o-cresolato)aluminum (III), and bis(2-methyl-6-trifluoromethyl-8-quinolinolato)(2-naphtholato)aluminum (III).

Besides, use may be made of bis(2-methyl-8-quinolinolato)aluminum (III)-μ-oxo-bis(2-methyl-8-quinolinolato) aluminum (III), bis(2,4-dimethyl-8-quinolinolato)aluminum (III)-μ-oxo-bis(2,4-dimethyl-8-quinolinolato)aluminum (III), bis(4-ethyl-2-methyl-8-quinolinolato)aluminum (III)-μ-oxo- bis(4-ethyl-8-quinolinolato)aluminum (III), bis(2-methyl-4-methoxyquinolinolato) aluminum (III)-μ-oxo-bis(2-methyl-4-methoxyquinolinolato)aluminum (III), bis(5-cyano-2-methyl-8-quinolinolato)aluminum (III)-μ-oxo-bis (5-cyano-2-methyl-8-quinolinolato)aluminum (III), bis(2-methyl-5-trifluoromethyl-8-quinolinolato)aluminum (III)-μ-oxo-bis(2-methyl-5-trifluoromethyl-8-quinolinolato)aluminum (III), etc.

Other preferable host substances include phenylanthracene derivatives disclosed in JP-A 8-12600 (Japanese Patent Application No. 6-110569), tetraarylethene derivatives disclosed in JP-A 8-12969 (Japanese Patent Application No. 6-114456), etc.

In the present invention, the light emitting layer may also serve as an electron injecting and transporting layer. In this case, it is preferable to use a fluorescent material, e.g., tris(8-quinolinolato)aluminum or the like.

For the compounds capable of injecting and transporting electrons, it is preferable to use metal complexes containing quinoline derivatives, especially 8-quinolinol or its derivatives as ligands, in particular, tris(8-quinolinolato) aluminum (Alq3). It is also preferable to use the aforesaid phenylanthracene derivatives, and tetraarylethene derivatives.

For the compounds for the injection and transportation of holes, it is preferable to use amine derivatives having strong fluorescence, for instance, triphenyldiamine derivatives, styrylamine derivatives, and amine derivatives having an aromatic fused ring.

Preferably, the pressure for evaporation should be $1 \times 10^{-8}$ to $1 \times 10^{-5}$ Torr, and the evaporation source should preferably be heated to a temperature of about 100 to 1,400°C for metal materials and to a temperature of about 100 to 500°C for organic materials.

The substrate is not critical to the practice of the present invention provided that thin films for constituting an organic EL display device can be laminated thereon. The substrate, when it is located on the side out of which light is taken, may be formed of a transparent or semi-transparent material, for instance, glass, quartz, and resin. The substrate may further be used in combination with a color filter film, fluorescent material-containing color conversion film or dielectric reflecting film for controlling the color of light emission. The substrate, when it is located on the side out of which the emitted light is not taken, may be either transparent or opaque. Ceramics, etc. may be used for an opaque substrate.

The size of the substrate, too, is not critical to the practice of the present invention. However, the substrate should preferably have a maximum length, esp., a diagonal length of 200 to 1,000 mm, and especially 400 to 700 mm. Although no problem arises at a maximum length of less than 200 mm, yet a substrate having a maximum length of 200 mm or greater is preferable because a uniform film-thickness distribution is achievable. A substrate of greater than 1,000 mm in size is not preferable because a film-formation system becomes large, resulting in a drop of film-formation efficiency and making film thickness control difficult.

A more illustrative construction of the fabrication system according to the invention will now be explained with reference to the drawings.

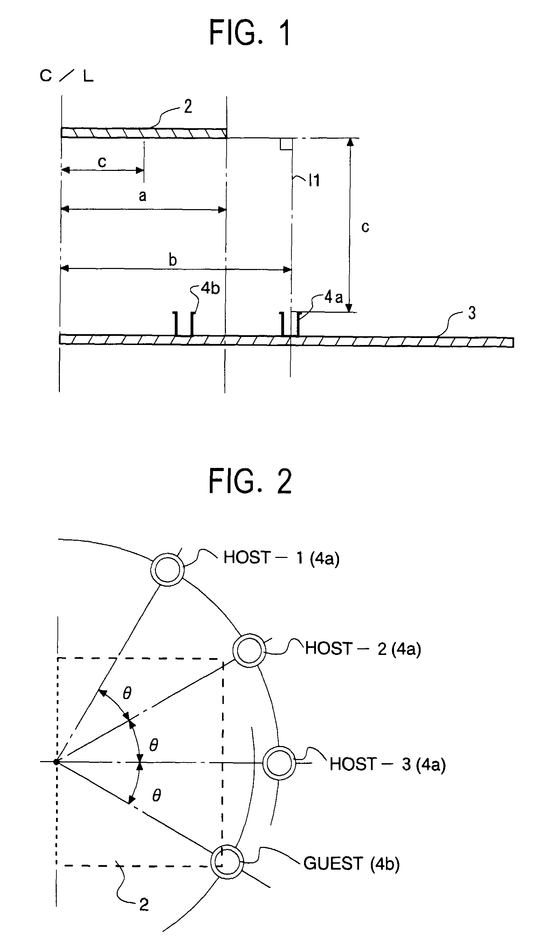

Fig. 1 is a sectional view illustrating a half of the basic construction of the present system. As illustrated, the organic EL display device fabrication system of the present invention comprises a substrate 2, a table 3 with evaporation sources placed thereon and a plurality of evaporation sources 4. Illustrated in Fig. 1 is a right half of the fabrication system with respect to the center C/L of the substrate 2. Thus, the evaporation source 4a for the host material is located at a position between the center-to-end distance a of the substrate and a distance b that is twice as long as the distance a, and the evaporation source 4b for the guest material is located at a position between a distance c that is 0.5 times as long as the center-to-end distance a of the substrate and the center-to-end distance a of the substrate, with a vertical distance c from an opening 24 in the evaporation source 4 to the substrate 2 being 1.0 to 3.5 times as long as the center (C/L)-to-end distance of the substrate 2. It is here noted that the position of the evaporation source 4 (4a, 4b) is defined by the center position of the opening in the evaporation source 4.

The evaporation source 4 is also inclined with respect to the side of the substrate 2 such that a center line of the evaporation source 4 passing vertically through the surface of the opening is at an angle θ2 of 1 to 45 degrees, preferably 3 to 30 degrees and especially 5 to 20 degrees with respect to a perpendicular 11 going from a plane including the substrate surface down to the evaporation source 4.

Fig. 2 is a plan view of the Fig. 1 system as viewed from above (from the substrate side). In this example, the evaporation sources 4a and 4b are each disposed at an angle θ of 30° as viewed from the center of the substrate. Here given a circular cylinder crossing vertically the substrate surface and having a radius R that is 0 to 0.5 times and preferably 0 to 0.2 times as long as the center-to-end distance of the substrate, it is then preferable that the center line of the evaporation source 4 crosses the circular cylinder. More preferably, the center line of the evaporation source 4 crosses the center of rotation of the substrate.

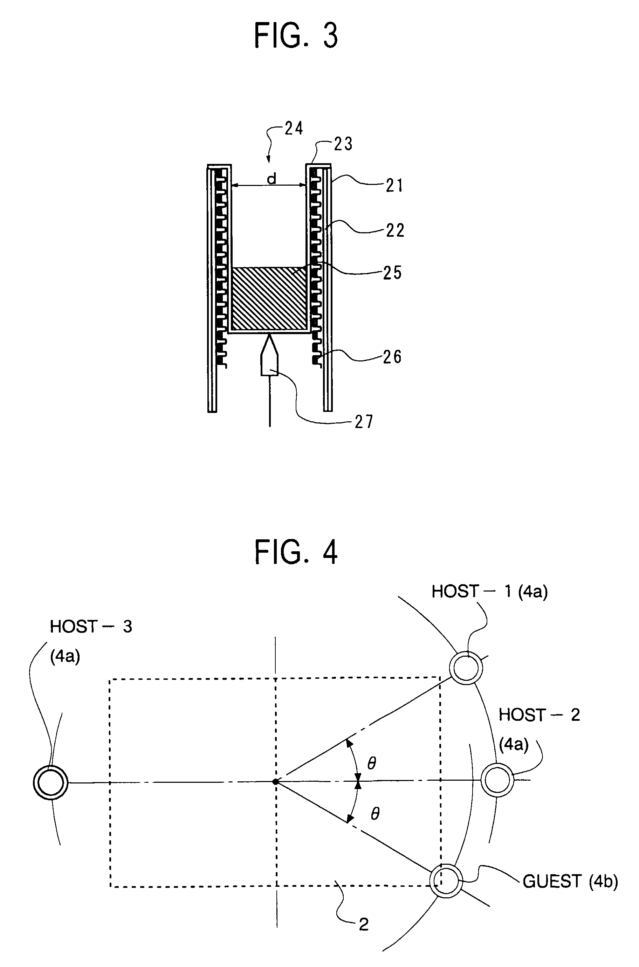

Fig. 3 is a sectional view of part of a more specific embodiment of the evaporation source 4 preferably used in the present invention. As illustrated, the evaporation source 4 comprises an outer case 21, a heat insulator 22, a crucible 23, an opening 24, a material 25, a heating means 26 and a temperature sensor means 27.

The crucible 23 should preferably be made up of a material less susceptible to chemical reaction with the material 25 to be evaporated and capable of standing up to a given temperature, for instance, ceramics such as pyrolytic boron nitride (PBN) and alumina, and quartz, with PBN being particularly preferred. Preferably but not exclusively, the outer case 21 should be made up of a material having given strength, corrosion resistance, etc. For instance, an appropriate selection may be made from the following materials for the heat insulator 22. Alternatively, the outer case 21 may be formed of the heat insulator 22. The heat insulator 22 may be made up of a material having heat reflection, heat resistance, corrosion resistance, etc., for instance, molybdenum, tantalum, stainless steel (SUS 316), Inconel, cow-wool, and asbestos.

For the heating means 26, use may be made of any desired device having given heat capacity, reactivity, etc., for instance, a tantalum wire heater and a sheath heater. By the heating means 26, the evaporation source should preferably be heated to a temperature of about 100 to 1,400°C, and precision of temperature control should be typically about ±1°C and preferably about ± 0.5°C at 1,000°C, although varying depending on the material to be evaporated. The temperature sensor means 27 may be a sensor capable of providing correct detection of the temperature of the material 25 in the crucible 23, which sensor may be made up of a thermocouple such as a platinum/platinum-rhodium, and tungsten/tungsten-rhenium.

EXAMPLES

The present invention will now be explained more specifically with reference to examples.

Example 1

As shown in Fig. 2, a substrate of 300 mm x 400 mm in size was provided in a vacuum tank. Three evaporation sources for the host material were located at positions spaced 300-mm away from the center of the substrate, and one evaporation source for the guest material was located at a position spaced 240-mm away from the center of the substrate. In this case, the vertical distance from a plane including the substrate surface to the opening in each evaporation source was fixed at 500 mm, and the center positions of adjacent evaporation sources made an angle θ of 30 degrees with each other as viewed from the center of the substrate.

The evaporation sources were disposed in the order of host-1, host-2, guest, and host-3.

Then, each evaporation source was used to form a single layer by evaporation, the film thickness distribution of which was in turn measured.

While the substrate was rotated, the evaporation source-1 for the host material was used for the evaporation of m-MTDATA (N,N-diphenyl-N,N'-m-tolyl-4,4',4,4',4"-tris(-N-(3-methylphenyl)-N-phenylamino) triphenylamine)). At this time, the rate of film deposition on the substrate was 1.0 Å while the n value for the evaporation source was n = 6. The film was formed to a thickness of 1,000 Å. By measurement, the variation in the film thickness distribution in the substrate surface was found to be limited to within ± 3%.

While the substrate was rotated, the evaporation source-2 for the host material was used for the evaporation of TPD (N,N'-diphenyl-N,N'-m-tolyl-4,4'-diamino-1,1'-biphenyl (triphenylamine)). At this time, the rate of film deposition on the substrate was 1.0 Å while the n value for the evaporation source was n = 6. The film was formed to a thickness of 1,000 Å. By measurement, the variation in the film thickness distribution in the substrate surface was found to be limited to within ± 3%.

While the substrate was rotated, the evaporation source-3 for the host material was used for the evaporation of Alq3 (tris(8-quinolinolato)aluminum). At this time, the rate of film deposition on the substrate was 1.0 Å while the n value for the evaporation source was n = 6. The film was formed to a thickness of 1,000 Å. By measurement, the variation in the film thickness distribution in the substrate surface was found to be limited to within ± 3%.

While the substrate was rotated, the evaporation source for the guest material was used for the evaporation of rubrene. At this time, the rate of film deposition on the substrate was 0.01 Å while the n value for the evaporation source was n = 12. The film was formed to a thickness of 500 Å. By measurement, the variation in the film thickness distribution in the substrate surface was found to be limited to within ± 7%.

In addition, this film-formation system was used to fabricate an organic EL device.

An ITO film of 1,000 Å in thickness was formed on a glass substrate of 300 mm x 400 mm in size and 0.7 mm in thickness, and a pattern corresponding to a pixel pattern of an organic EL device was formed thereon with an inter-layer insulating film and a cathode separation structure, thereby obtaining a substrate.

This substrate was placed in a vacuum chamber, which was then evacuated to a vacuum of $1 \times 10^{-4}$ Pa or less. While the substrate was rotated at 10 rpm, the evaporation source-1 for the host material was used for the evaporation at a film-deposition rate of 10 Å/sec. of m-MTDATA to a thickness of 400 Å on the substrate. Following this, the evaporation source-2 for the host material was used for the evaporation at a film-deposition rate of 1.0 Å/sec. of TPD to a thickness of 350 Å. In addition, while the evaporation source-3 for the host material was used for the evaporation at a film-deposition rate of 1.0 Å/sec. of Alq3 to a thickness of 500 Å, the evaporation source for the guest material adjacent thereto was used for the evaporation at a film-deposition rate of 0.01 Å/sec. of rubrene, thereby effecting doping for a light emitting layer.

With the vacuum condition still maintained, MgAg was formed by co-evaporation (binary evaporation) to a thickness of 200 nm at a deposition rate ratio of Mg:Ag = 10:1 to obtain an electron injecting electrode.

The obtained organic EL device was driven on a constant current having a current density of 10 mA/$cm^2$ in a dry air atmosphere to measure a luminance distribution within the substrate surface. The luminance was 1,000 cd/$m^2$ on the average in the substrate surface, with its distribution in the substrate surface being limited to within ± 5%.

Comparative Example 1

An organic EL device was prepared following Example 1 with the exception that the evaporation source for the guest material was located at a position spaced 300-mm away from the center of the substrate. Then, the film thickness distribution and luminance distribution in the substrate surface were measured.

As a result, the film-thickness distribution of rubrene obtained by the evaporation source for the guest material was found to be $\pm$ 27%. The luminance of the obtained organic EL device was 900 cd/m$^2$ on the average in the substrate surface, with its distribution in the substrate surface being $\pm$ 20% or greater.

Example 2

Following Example 1, TPD was formed to a thickness of 350 Å. Then, while the evaporation source-2 for the host material was used for the evaporation of TPD at a film-deposition rate of 1.0 Å/sec., the evaporation source-3 for the host material was used for the evaporation of Alq3 at a film-deposition rate of 1.0 Å/sec. simultaneously with the evaporation by the evaporation source for the guest material of rubrene at a rate of 0.01 Å/sec., thereby obtaining a ternary deposited layer of 500 Å in thickness. In addition, the evaporation source-3 for the host material was used for the evaporation with a thickness of 100 Å of Alq3 at a film-deposition rate of 1.0 Å/sec. Then, an electron injecting electrode was formed following Example 1, thereby obtaining an organic EL device.

The obtained organic EL device was found to have a luminance of 1,000 cd/m$^2$ or greater in the substrate surface, with its distribution in the substrate surface being limited to within $\pm$ 5%. After the device was driven on a constant current having a current density of 10 mA/cm$^2$ in a dry air atmosphere, the half-life of its luminance exceeded about 10,000 hours.

Comparative Example 2

An organic EL device was prepared and estimated as in Example 2 with the exception that, as shown in Fig. 4, the evaporation source-2 for the host material and the evaporation source-3 for the host material made an angle of 180 degrees with each other as viewed from the center of the substrate and the substrate was rotated at 3 rpm.

The obtained organic EL device was found to have a luminance of 900 cd/m$^2$ or less on the average in the substrate surface, with its distribution in the substrate surface being $\pm$ 20% or greater. After the device was driven on a constant current having a current density of 10 mA/cm$^2$ in a dry air atmosphere, the half-life of its luminance did not reach about 6,000 hours.

ADVANTAGES OF THE INVENTION

According to the invention as explained above, it is possible to provide an organic EL display fabrication system and method which are well compatible with a substrate having a relatively large area and ensure a small film-thickness distribution, high material usage efficiency, a high practical rate during film formation and a constant doping concentration, and so enable organic EL display devices of high quality to be mass-fabricated with efficiency yet at low cost.

Japanese Patent Application No. 11-233654 is herein incorporated by reference.

While the invention has been described in detail and with reference to specific embodiments thereof, it will be apparent to one skilled in the art that various changes and modifications may be made therein without departing from the spirit and scope thereof.

**Claims**

1. An organic electroluminescent display device fabrication system comprising a substrate on which said organic EL display device is to be formed, a means for rotating said substrate, an evaporation source for a host material and an evaporation source for a guest material, wherein:

an n value is 3 to 10 for said evaporation source for a host material and 8 to 18 for said evaporation source for a guest material as given by an approximate equation $m/m_0 = (L_0/L)^2 \cdot \cos^n \theta$ where $m_0$ is a vapor density at a center on an opening in each evaporation source and at a distance $L_0$ from said opening and m is a vapor density at any position located at a radial angle $\theta$ from a center line of said opening and spaced away from said opening by a distance L,
said evaporation source for a host material is positioned with respect to a center of said substrate such that said evaporation source is located at a position that is 1.0 to 2.0 times as long as a center-to-end distance of said substrate,
said evaporation source for a guest material is positioned with respect to the center of said substrate such that said evaporation source is located at a position that is 0.5 to 1.0 time as long as the center-to-end distance of said substrate,
a vertical distance from said opening in each evaporation source to a plane including a substrate surface is 1.0 to 3.5 times as long as the center-to-end distance of said substrate, and
said evaporation source for a host material and said evaporation source for a guest material are simultaneously used for simultaneous evaporation of at least two materials.

2. The fabrication system according to claim 1, wherein a center line of each evaporation source is at an angle of 1 to 45 degrees with respect to a perpendicular going from said plane including the substrate surface down to each evaporation source.

3. The fabrication system according to claim 1 or 2, wherein said substrate has a maximum length of 200 to 1,000 mm.

4. The fabrication system according to any one of claims 1 to 3, wherein an organic layer to be formed has a film-thickness distribution of ± 10% or less.

5. The fabrication system according to any one of claims 1 to 4, wherein a rate of evaporation of said guest material is within 0.1 to 10% of a rate of evaporation of said host material.

6. The fabrication system according to any one of claims 1 to 5, wherein center positions of said evaporation sources subjected to said simultaneous evaporation are located within an angle of 90° as viewed from the center of said substrate.

7. The fabrication system according to any one of claims 1 to 6, wherein during evaporation said substrate is rotated by said rotation means at a rate of at least 10 rpm.

8. An organic electroluminescent display device fabrication method, wherein film formation is effected by a system as recited in any one of claims 1 to 7.

9. The fabrication method according to claim 8, wherein evaporation is effected such that a film thickness of 10 Å or less is obtained per rotation of said substrate.

10. The fabrication method according to claim 8 or 9, wherein a doped layer to be formed has a concentration distribution in a thickness direction thereof, with a maximum value of concentration thereof being at most 3 times as large as an average value of concentration in said layer.

# FIG. 1

# FIG. 2

# FIG. 3

# FIG. 4